# EUROPEAN PATENT SPECIFICATION

(11) **EP 1 746 641 B1**
(45) Date of publication and mention of the grant of the patent: **24.08.2011**
(21) Application number: 06715178.7
(22) Date of filing: 03.03.2006
(51) Int. Cl.: H01L 21/338, H01L 21/205, H01L 29/778, H01L 29/812

(54) **Method of manufacturing a group III nitride semiconductor device and epitaxial substrate**
Herstellungsverfahren für ein Gruppe III-Nitrid-Halbleiterbauelement und epitaktisches Substrat
Procédé de fabrication d'un dispositif semi-conducteur de nitrure de groupe III et d'un substrat épitaxial

(30) Priority: 15.03.2005 JP 2005073519; 27.01.2006 JP 2006019502
(43) Date of publication of application: 24.01.2007
(73) Proprietor: Sumitomo Electric Industries, Ltd., Osaka-shi, Osaka 541-0041 (JP)
(72) Inventor: TANABE, Tatsuya c/o Itami W. of Sum.Elec.Ind.,Ltd., Hyogo (JP); KIYAMA, Makoto c/o Itami W. of Sum. Elec. Ind.,Ltd, Hyogo (JP); MIURA, Kouhei c/o Osaka W. of Sum.Elec.Ind.,Ltd., Osaka (JP); SAKURADA, Takashi c/o Osaka W. of Su.Elec.Ind.,Ltd, Osaka (JP)
(74) Representative: Grünecker, Kinkeldey, Stockmair & Schwanhäusser Anwaltssozietät
(86) International application number: PCT/JP2006/304095
(87) International publication number: WO 2006/098167

(56) References cited:
- WO-A-2004/061923
- JP-A- 2002 289 528
- JP-A- 2003 059 946
- JP-A- 2003 243 424
- JP-A- 2004 327 882
- US-A1- 2001 023 964
- MANFRA M J ET AL: "High-mobility AlGaN/GaN heterostructures grown by molecular-beam epitaxy on GaN templates prepared by hydride vapor phase epitaxy" APPLIED PHYSICS LETTERS, AIP, AMERICAN INSTITUTE OF PHYSICS, MELVILLE, NY, US, vol. 77, no. 18, 30 October 2000 (2000-10-30), pages 2888-2890, XP012026504 ISSN: 0003-6951
- MISKYS C R ET AL: "GaN homoepitaxy by metalorganic chemical-vapor deposition on free-standing GaN substrates" APPLIED PHYSICS LETTERS, AIP, AMERICAN INSTITUTE OF PHYSICS, MELVILLE, NY, US, vol. 77, no. 12, 18 September 2000 (2000-09-18), pages 1858-1860, XP012026182 ISSN: 0003-6951
- LIU L ET AL: "Substrates for gallium nitride epitaxy" MATERIALS SCIENCE AND ENGINEERING R: REPORTS, ELSEVIER SEQUOIA S.A., LAUSANNE, CH, vol. 37, no. 3, 30 April 2002 (2002-04-30), pages 61-127, XP004349792 ISSN: 0927-796X
- ACTIS R ET AL: "9.4-W/mm Power Density AlGaN-GaN HEMTs on Free-Standing GaN Substrates", IEEE ELECTRON DEVICE LETTERS, IEEE SERVICE CENTER, NEW YORK, NY, US, vol. 25, no. 9, 1 September 2004 (2004-09-01), pages 596-598, XP011117930, ISSN: 0741-3106, DOI: DOI:10.1109/LED.2004.833847

## Description

### Technical Field

The present invention relates to a method of manifacturing a Group III nitride epitaxial substrates.

### Background Art

In Non-Patent Document 1, high electron mobility transistors (HEMT) are disclosed. The high electron mobility transistors have an AlGaN/GaN heterostructure epitaxially grown on a sapphire substrate. In order to manufacture the high electron mobility transistors, after forming a low-temperature GaN layer on the sapphire substrate, an *i-*type GaN layer of 2 to 3 µm is formed. On the GaN layer, an *i-*type AlGaN layer of 7 nm, an n-type AlGaN layer of 15 nm, and an *i-*type AlGaN layer of 3 nm are formed in that order. The Schottky electrode is composed of Ni(3 nm)/Pt(300 nm)/Au(300 nm). Non-Patent Document 1: "Improvement of DC Characteristics of AlGaN/GaN High Electron Mobility Transistors Thermally Annealed Ni/Pt/Au Schottky Gate" Japanese Journal of Applied Physics Vol. 43, No. 4B, 2004, pp.1925-1929.

WO2004061923 (fig. 1; p. 41,I. 12 - p. 44, I. 10) discloses a method of manufacturing an epitaxial substrate for a group III nitride semiconductor device, comprising the steps of:
- providing a single-crystal GaN substrate (p. 42, I. 8);
- growing by MOVPE by supplying TMG, TMA and NH₃ (p. 41, I. 12-32) the following layers:
   - an undoped GaN epitaxial layer (p. 42,I. 8 21) having a thickness between 300nm and 20µm and a carrier concentration below 5x10¹⁶cm⁻³;
   - an AlGaN epitaxial layer (p. 42, I. 30-32) having an aluminum mole fraction of about 0.2-0.3 and having a thickness between 5nm and 50nm;
"9.4-W/mm Power Density AlGaN-GaN HEMTs on Free-Standing GaN Substrates" from Actis and al. discloses a method of manufacturing method an AlGaN/GaN HEMT on a free-standing GaN substrate, comprising:
- providing a free-standing HVPE GaN substrate;
- growing by MOCVD an epitaxial 100nm undoped GaN film formed on the HVPE GaN substrate;
- growing by MOCVD an epitaxial 27nm undoped Al_{0.28}Ga_{0.72}N film formed on the undoped GaN film;
wherein the surface of the homo-epitaxial film has a RMS roughness of less than 0.2nm.

"High-mobility AlGaN/GaN heterostructures grown by molecular-beam epitaxy on GaN templates prepared by hydride vapor phase epitaxy" from Manfra et al. discloses a method of manufacturing an AlGaN/GaN HEMT device on a free-standing device, comprising the steps of:
- providing a HVPE GaN substrate:
- growing by MBE a 0.5µm undoped GaN epitaxial layer;
- growing by MBE a 30nm Al_{0.09}Ga_{0.91}N epitaxial layer;
- the MBE-grown AlGaN layer exhibiting a very smooth surface with the landscape dominated by monolayer steps.

"GaN homoepitaxy by metalorganic chemical-vapor deposition on free-standing GaN substrates" from Miskys et al. discloses a method of homoepitaxially growing a GaN layer on a free-standing HVPE GaN substrate, the GaN homoepitaxial layer exhibiting a very smooth surface morphology with a RMS roughness of about 0.4nm.

### Disclosure of Invention

### Problems to be Solved by the Invention

In epitaxial substrates for HEMT manufactured by conventional technology, the Schottky gate is formed on the episurface of the AlGaN film. If the epitaxial substrates are utilized to manufacture the high electron mobility transistors, the withstand voltage between gate and drain is low and high output power is not attained. The cause is thought to be that the leakage current from the gate electrode is large. In addition, according to experiments by the inventors, the AlGaN film includes grooves as well as a number of method of manufacturing an dislocations. If a gate electrode is formed on a surface of the AlGaN film, an interface state is formed due to the method of manufacturing an dislocations and grooves, thereby lowering the Schottky barrier. As a result, the leakage current from the gate electrode becomes large.

Although it is necessary to improve the crystal quality of the AlGaN film in order to lower the interface state, it is not easy to improve the crystal quality as expected. The inventors have conducted various experiments in order to investigate which kind of crystal quality of the AlGaN film is related to the leakage current from the gate electrode.

It is an object of the present invention to make available Group III nitride semiconductor devices in which the leakage current from the gate electrode is reduced. It is another object of the present invention to make available epitaxial substrates for manufacturing the Group III nitride semiconductor devices.

### Means to Solve the Problem

According to the invention, there is provided a method of manufacturing an epitaxial substrate according to claim 1. device.

According to experiments by the inventors, it has been found that the leakage current from the Schottky electrode in contact with the Al*y*Ga_{1-*y*}N epitaxial layer (0<*y*≤1) is related to the surface roughness (RMS) defined by a square area measuring 1 µm per side. According to the present invention, since the surface roughness is 0.25 nm or less, the leakage current from the Schottky electrode can be reduced.

In a Group III nitride semiconductor device involving the present invention, it is preferable that aluminum mole fraction *y* of the Al*y*Ga_{1*-y*}N epitaxial layer be between 0.1 and 0.7, inclusive.

If the aluminum mole fraction *y* is less than 0.1, the band offset becomes small so that two-dimensional electron gas having enough density at the AlGaN/GaN interface is not formed. If the aluminum mole fraction *y* is more than 0.7, it is highly likely that cracks are generated in the AlGaN layer. The generation of the cracks prevents the two-dimensional electron gas from being formed at the AlGaN/GaN interface.

If the thickness of the Al*y*Ga_{1-*y*}N epitaxial layer is less than 5 nm, the distortion at the AlGaN/GaN interface becomes small so that the two-dimensional electron gas can not be formed. If the thickness of the Al*y*Ga_{1-*y*}N epitaxial layer is more than 50 nm, it is highly likely that the cracks are generated in the AlGaN layer. The generation of the cracks prevents the two-dimensional electron gas from being formed at the AlGaN/GaN interface.

In a Group III nitride semiconductor device involving the present invention, it is preferable that the supporting substrate be composed of gallium nitride. As a result, a Group III nitride semiconductor device can be provided using a supporting substrate having a low dislocation density.

According to experiments by the inventors, it has been found that the leakage current from the Schottky electrode in contact with the Al*y*Ga_{1-*y*}N epitaxial layer (0<*y*≤1) is related to the surface roughness (RMS) defined by a square area measuring 1 µm per side. According to the epitaxial substrate, since the surface roughness (RMS) defined by a square area measuring 1 µm per side is 0.25 nm or less, the Schottky electrode formed on the Al*y*Ga_{1-*y*}N epitaxial layer shows a small leakage current. Consequently, an epitaxial substrate preferable for a high electron mobility transistor can be provided.

In an epitaxial substrate involving the present invention, it is preferable that aluminum mole fraction *y* of the Al*y*Ga_{1-*y*}N epitaxial film be between 0.1 and 0.7, inclusive.

If the aluminum mole fraction *y* of the Al*y*Ga_{1-*y*}N epitaxial film is smaller than 0.1, the band offset becomes small so that two-dimensional electron gas having enough density at the AlGaN/GaN interface is not formed. If the aluminum mole fraction *y* of the Al*y*Ga_{1-*y*}N epitaxial film is more than 0.7, it is highly likely that cracks are generated in the AlGaN layer. The generation of the cracks prevents the two-dimensional electron gas from being formed at the AlGaN/GaN interface.

If the thickness of the Al*y*Ga_{1-*y*}N epitaxial layer is less than 5 nm, the distortion at the AlGaN/GaN interface becomes small so that the two-dimensional electron gas can not be formed. If the thickness of the Al*y*Ga_{1-*y*}N epitaxial layer is more than 50 nm, it is highly likely that the cracks are generated in the AlGaN layer. The generation of the cracks prevents the two-dimensional electron gas from being formed at the AlGaN/GaN interface.

In an epitaxial substrate involving the present invention, it is preferable that the substrate be a gallium nitride substrate. As a result, an epitaxial substrate can be provided for a Group III nitride semiconductor device using a substrate having a low dislocation density.

### Advantageous Effect of the Invention

As described above, according to the present invention, a Group III nitride semiconductor device can be afforded in which the leakage current from the Schottky electrode is decreased. Furthermore, according to the present invention, an epitaxial substrate can be afforded for manufacturing the Group III nitride semiconductor device.

### Brief Description of Drawings

Fig. 1 is a view representing the high electron mobility transistor involving Embodiment Mode 1 which is not prtt of the invention.
Fig. 2A is a view representing the structure of the high electron mobility transistor (HEMT) in Embodiment Example.
Fig. 2B is a view representing the structure of the HEMT in Experiment.
Fig. 3A is a view representing the atomic force microscope (AFM) image on the surface of the AlGaN layer of the epitaxial substrate (sample A) manufactured for the high electron mobility transistor.
Fig. 3B is a view representing the atomic force microscope (AFM) image on the surface of the AlGaN layer of the epitaxial substrate (sample B).
Fig. 4 is a view representing the correspondence between the surface roughness (RMS) and the leakage current density of the AlGaN layer.
Fig. 5A is a view representing the manufacture of the epitaxial substrate involving Embodiment Mode 2.
Fig. 5B is a view representing the manufacture of the epitaxial substrate involving Embodiment Mode 2.
Fig. 5C is a view representing the manufacture of the epitaxial substrate involving Embodiment Mode 2.
Fig. 6 is a view representing one example of locations of the high dislocation regions and the low dislocation regions in the gallium nitride freestanding substrate for Embodiment Modes 1 and 2.
Fig. 7 is a view representing another example of locations of the high dislocation areas and the low dislocation areas in the gallium nitride freestanding substrate for Embodiment Modes 1 and 2.
Fig. 8 is a view representing the high electron mobility transistor according to one modification of Embodiment Mode 1.
Fig. 9 is a view representing the high electron mobility transistor according to other modification of Embodiment Mode 1.
Fig. 10 is a view representing the high electron mobility transistor according to other modification of Embodiment Mode 1.
Fig. 11 is a view representing the high electron mobility transistor according to other modification of Embodiment Mode 1.

### Explanation of Referenced Numerals

1, 1a, 1b, 1c, 1d: high electron mobility transistor; 3: supporting substrate; 4: additional gallium nitride semiconductor layer; 5, 5a: Al*y*Ga_{1-*y*}N epitaxial layer (0<*y*≤1); 6: contact layer; 7: GaN epitaxial layer;9, 9a: Schottky electrode; 11, 11a, 11b: first ohmic electrode; 13, 13a, 13b: second ohmic electrode; 21: gallium nitride substrate; 23: gallium nitride layer; 25: AlGaN layer; A, B: epitaxial substrate; 27a: source electrode; 27b: drain electrode; 29: gate electrode; 31: sapphire substrate; 32: seed layer; 33: gallium nitride layer; 35: AlGaN layer; 37a: source electrode; 37b: drain electrode; 80: reactor; 83: gallium nitride freestanding substrate; 85: GaN epitaxial film; 87: AlGaN epitaxial film; 81: epitaxial substrate; 82: gallium nitride freestanding substrate; 82c: high dislocation region; 82d: low dislocation region; 84: gallium nitride supporting substrate; 84c: high dislocation region; 84d: low dislocation region.

### Best Mode for Carrying Out the Invention

Insights into the present invention will be readily understood in conjunction with the following detailed description with reference to the accompanying figures for illustration. Hereinafter, referring to the accompanying figures, embodiments according to Group III nitride semiconductor devices and epitaxial substrates of the present invention will be described. In the embodiments, high electron mobility transistors as a Group III nitride semiconductor device will be described. Note that where possible identical components are labeled with the same reference marks.

### Embodiment Mode 1 (not part of the invention)

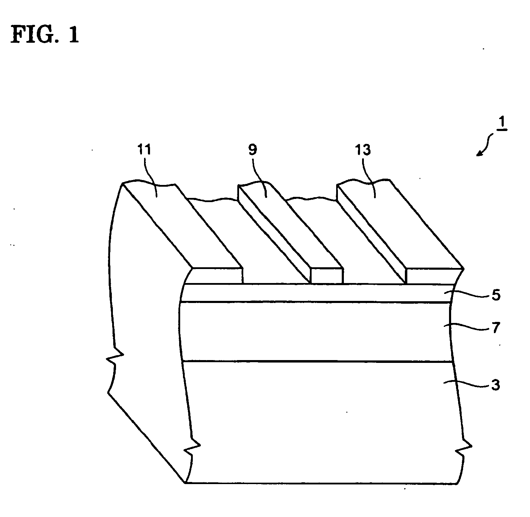

Fig. 1 is a view representing a high electron mobility transistor according to Embodiment Mode 1. The high electron mobility transistor 1 includes a supporting substrate 3, an Al*y*Ga_{1-*y*}N epitaxial layer (0<*y*≤1) 5, a GaN epitaxial layer 7, a Schottky electrode 9, a first ohmic electrode 11, and a second ohmic electrode 13. The supporting substrate 3 is composed of Al*ₓ*Ga_{1-*x*}N (0≤*x*≤1), more specifically, AlN, AlGaN, or GaN. The Al*_{y}*Ga_{1-*y*}N epitaxial layer 5 has a surface roughness (RMS) of 0.25 nm or less, and the surface roughness is defined by a square measuring 1 µm per side. The GaN epitaxial layer 7 is provided between the Al*_{y}*Ga_{1-*y*}N supporting substrate 3 and the Al*_{y}*Ga_{1-*y*}N epitaxial layer 5. The Schottky electrode 9 is provided on the Al*_{y}*Ga_{1-*y*}IV epitaxial layer 5. The first ohmic electrode 11 is provided on the Al*_{y}*Ga_{1-*y*}N epitaxial layer 5. The second ohmic electrode 13 is provided on the Al*_{y}*Ga_{1-*y*}N epitaxial layer 5. One of the first and second ohmic electrodes 11 and 13 constitutes a source electrode, and the other constitutes a drain electrode. The Schottky electrode 9 constitutes a gate electrode of the high electron mobility transistor 1.

The inventors have found that the leakage current from the Schottky electrode 9 in contact with the Al*_{y}*Ga_{1-*y*}N epitaxial layer (0<*y*≤1) 5 is related to the surface roughness (RMS) of a square area measuring 1 µm per side. According to the present invention, since the surface roughness is 0.25 nm or less, the leakage current from the Schottky electrode 9 is reduced.

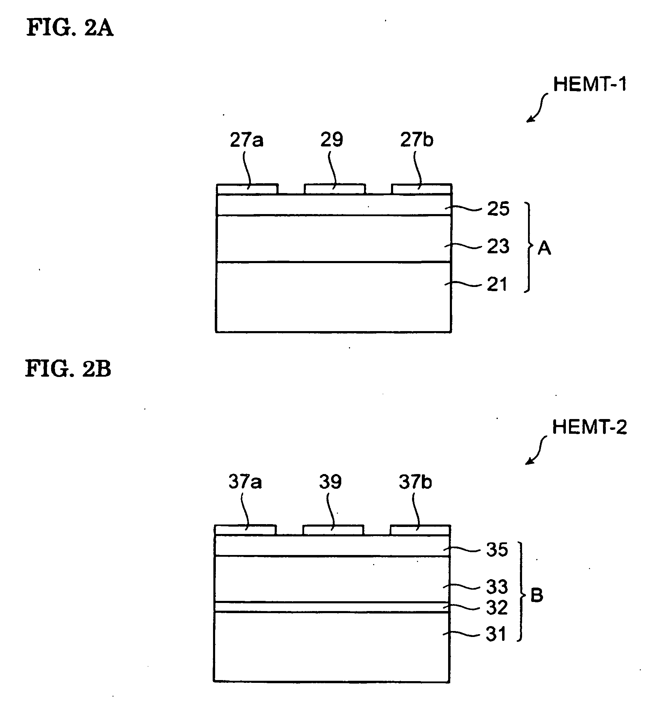

Fig. 2A is a view representing the structure of the high electron mobility transistor (HEMT) according to Example. Fig. 2B is a view representing the structure of the HEMT according to Experiment.

### Embodiment Example 1

A gallium nitride substrate 21 is placed in a reactor of an MOVPE device. After gases including hydrogen, nitrogen, and ammonia are supplied into the reactor, the gallium nitride substrate 21 undergoes a heat treatment. The heat treatment is performed at 1100 degrees Celsius for about 20 minutes, for example. Next, the temperature of the gallium nitride substrate 21 is increased to 1130 degrees Celsius, for example. Ammonia and trimethylgallium (TMG) are supplied into the reactor to grow a gallium nitride layer 23 of a thickness of 1.5 µm on the gallium nitride substrate 21. The gallium nitride layer 23 has a thickness of 1.5 µm, for example. Trimethyl aluminum (TMA), TMG, and ammonia are supplied into the reactor to grow an AlGaN layer 25 on the gallium nitride layer 23. The AlGaN layer 25 has a thickness of 30 nm, for example. By these processes, an epitaxial substrate A is manufactured. Then, a source electrode 27a and a drain electrode 27b of Ti/Al/Ti/Au are formed on a surface of the epitaxial substrate A, and a gate electrode 29 of Au/Ni is formed on the surface of the epitaxial substrate A. By these processes, an HEMT-1 shown in Fig. 2A is manufactured.

### Experiment 1

A sapphire substrate 31 is placed in the reactor of the MOVPE device. Gases including hydrogen, nitrogen, and ammonia are supplied into the reactor to heat-treat the sapphire substrate 31. The temperature of the heat treatment is 1170 degrees Celsius, and the heat treatment time is 10 minutes, for example. Next, a seed layer 32 is grown on the sapphire substrate 31. After that, as in Embodiment Example 1, a gallium nitride layer 33 and an AlGaN layer 35 are grown to manufacture an epitaxial substrate B. A source electrode 37a and a drain electrode 37b of Ti/Al/Ti/Au are formed, and a gate electrode 39 of Au/Ni is formed on the surface of the epitaxial substrate B. By these processes, an HEMT-2 shown in Fig. 2B is manufactured.

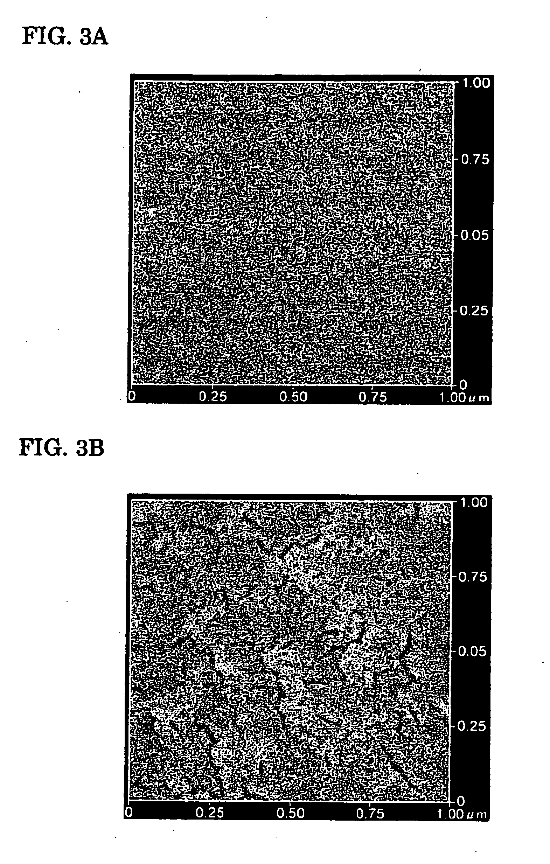

Fig. 3A and Fig. 3B are views representing atomic force microscope (AFM) images of the surfaces of the AlGaN layers of the epitaxial substrate (sample A) and the epitaxial substrate (sample B) manufactured for the high electron mobility transistors, respectively. Figures show images of a square area measuring 1 µm per side. The sample A includes a GaN film and an AlGaN film formed on the gallium nitride substrate in this order. The sample B includes a seed film, a GaN film and an AlGaN film formed on the sapphire substrate in this order. As shown in figures, the surface of the sample A is so flat that atomic layer steps can be observed, but the sample B has a number of grooves. On each of the AlGaN films, a Schottky electrode is provided to measure the leakage current. An area of the Schottky electrode is 7.85×10⁻⁵ cm² and the applied voltage is -5 volts, for example.

### Sample A

Surface roughness (RMS) in a square area measuring 1 µm per side: 0.071 (nm),
Leakage current density: 1.75×10⁻⁶ (A/cm²);

### Sample B

Surface roughness (RMS) in a square area measuring 1 µm per side: 0.401 (nm),
Leakage current density: 1.79×10⁻² (A/cm²).

The leakage current in Sample A is greatly lower than that of Sample B. The reason is that as far as the AlGaN layer is concerned, the surface roughness of Sample A is smaller than that of Sample B.

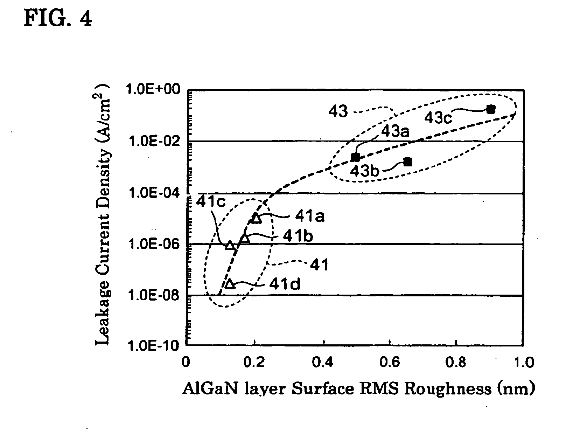

Fig. 4 is a view of representing correspondences between the surface roughness (RMS) of the AlGaN layer and the leakage current density. Symbols indicated by reference marks 41a through 41d represent values obtained by measuring the structure in which the Schottky electrode is formed on the AlGaN layer that is fabricated by utilizing the gallium nitride substrate. Symbols indicated by reference marks 43a through 43c represent values obtained by measuring the structure in which Schottky electrode is formed on the AlGaN layer that is fabricated by utilizing the sapphire substrate.

### Embodiment Example 2

To present specific examples:
Sample indicated by the reference mark 41a-
Surface roughness: 0.204 nm,
Leakage current density: 1.11×10⁻⁵ A/cm²;
Sample indicated by the reference mark 41b-
Surface roughness: 0.170 nm,
Leakage current density: 1.75×10⁻⁶ A/cm²;
Sample indicated by the reference mark 41c-
Surface roughness: 0.127 nm,
Leakage current density: 9.01×10⁻⁷A/cm²;
Sample indicated by the reference mark 41d-
Surface roughness: 0.127 nm,
Leakage current density: 2.72×10⁻⁸ A/cm².

### Experiment 2

To present specific examples:
Schottky diode structure indicated by reference mark 43a (with the smallest surface roughness)-
Surface roughness: 0.493 nm,
Leakage current density: 2.31×10⁻³ A/cm²;
Schottky diode structure indicated by reference mark 43b (with the smallest leakage current density)-
Surface roughness: 0.652 nm,
Leakage current density: 1.63×10⁻³ A/cm².

In the high electron mobility transistor 1, the supporting substrate 3 of nitride is composed of gallium nitride conductive or semi-insulating. In this example, the gallium nitride region is homoepitaxially grown on the gallium nitride supporting substrate. The carrier concentration of the gallium nitride supporting substrate is 1×10¹⁹ cm⁻³ or less. The GaN layer 7 has a thickness between 0.1 µm and 1000 µm, inclusive. The GaN layer 7 has a carrier concentration of 1×10¹⁷ cm⁻³ or less. The AlGaN layer 5 has a thickness between 5 nm and 50 nm, inclusive. The AlGaN layer 5 has a carrier concentration of 1×10¹⁹ cm⁻³ or less.

In the high electron mobility transistor 1, the aluminum mole fraction *y* of the Al*_{y}*Ga_{1-*y*}N epitaxial layer 5 is preferably 0.1 or more. If the aluminum mole fraction *y* is less than 0.1, the band offset becomes small and two-dimensional electron gas having enough density can not be formed at the AlGaN/GaN interface. The aluminum mole fraction *y* is preferably 0.7 or less. If the aluminum mole fraction *y* is more than 0.7, it is highly likely that cracks are generated in the AlGaN layer. The generation of the cracks prevents the two-dimensional electron gas from being formed at the AlGaN/GaN interface.

In the high electron mobility transistor 1, the Al*_{y}*Ga_{1-*y*}N epitaxial layer 5 preferably has a thickness of 5 nm or more. If the thickness of the Al*_{y}*Ga_{1-*y*}N epitaxial layer 5 is less than 5 nm, the distortion at the AlGaN/GaN interface becomes small and the two-dimensional electron gas is not formed. The Al*_{y}*Ga_{1-*y*}N epitaxial layer 5 preferably has a thickness of 50 nm or less. If the thickness of the Al*_{y}*Ga_{1-*y*}N epitaxial layer 5 is more than 50 nm, it is highly likely that cracks are generated in the AlGaN layer. The generation of the cracks prevents the two-dimensional electron gas from being formed at the AlGaN/GaN interface.

The Al*ₓ*Ga_{1-*x*}N supporting substrate for the high electron mobility transistor 1 is preferably composed of gallium nitride. Accordingly, Group III nitride semiconductor devices are provided using a supporting substrate of a low dislocation density.

### Embodiment Mode 2 according to the invention

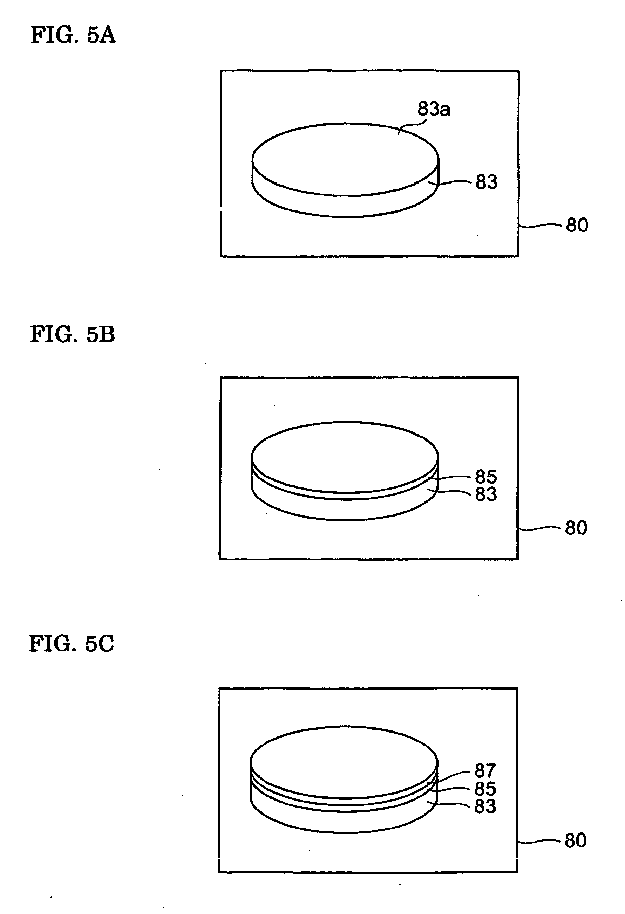

Fig. 5A, Fig. 5B, and Fig. 5C are views representing manufacture of the epitaxial substrate according to Embodiment Mode 2. As shown in Fig. 5A, a gallium nitride freestanding substrate 83 having conductivity is placed in a reactor 80. The following crystal growth is preferably performed by MOVPE method. The gallium nitride freestanding substrate 83 has a carrier concentration of 1×10¹⁹ cm⁻³ or less. As shown in Fig. 5B, by supplying TMG and NH₃, a GaN epitaxial film 85 is deposited on a first surface 83a of the gallium nitride freestanding substrate 83. The GaN epitaxial film 85 is preferably undoped. The GaN epitaxial film 85 is deposited at a temperature between 600 degrees Celsius and 1200 degrees Celsius, inclusive. The pressure in the reactor is between 1 kPa and 120 kPa, inclusive. The gallium nitride epitaxial film 85 has a thickness between 0.5 µm and 1000 µm, inclusive. The GaN epitaxial film 85 has a carrier concentration of 1×10¹⁷ cm⁻³ or less. If necessary, in advance of the growth of the GaN epitaxial film 85, a buffer layer can be grown. The buffer layer may be composed of any of AlN, GaN, AlGaN, InGaN, and AlInGaN. The buffer layer restrains defects or impurities of the gallium nitride freestanding substrate 83 from affecting the GaN epitaxial layer 85, so that quality of the GaN epitaxial layer 85 can be improved.
Next, as shown in Fig. 5C, TMA, TMG and NH₃ are supplied to deposit an undoped or n-type AlGaN epitaxial film 87 onto the undoped GaN epitaxial film 85. The AlGaN epitaxial film 87 is deposited at a temperature between 600 degrees Celsius and 1200 degrees Celsius, inclusive. The pressure in the reactor is between 1 kPa and 120 kPa, inclusive. The aluminum composition of the AlGaN epitaxial film 87 is between 0.1 and 0.7, inclusive. The AlGaN epitaxial film 87 has a thickness of 5 nm and 50 nm, inclusive. The AlGaN epitaxial film 87 has a carrier concentration of 1×10¹⁹ cm⁻³ or less. Accordingly, an epitaxial substrate 81 is obtained. By making use of this substrate, an HEMT according to Embodiment Mode 1 can be manufactured.

The inventors have found that the leakage current from the Schottky electrode in contact with the *Al_{y}Ga_{1-y}N* epitaxial film 87 (0<y≤1) is related to the surface roughness (RMS) measured using the atomic force microscope. Since the square area measuring 1 µm per side is sufficiently larger for surface structures of the epitaxial layer such as atomic layer steps or grooves, it is possible to use the surface roughness (RMS) in a square area measuring 1 µm per side to indicate flatness of the surface of the epitaxial layer. The forward current in the gate electrode of the HEMT is about 1 A/cm², therefore it is necessary to keep the leakage current 1×10⁻⁴ A/cm² or less, i.e., 1/100000 or less of the forward current. As shown in Fig. 4, since the surface roughness (RMS) of the Al*_{y}*Ga_{1-*y*}N epitaxial layer is 0.25 nm or less, the leakage current can be 1× 10⁻⁴ A/cm² or less.

Onto a surface of the AlGaN epitaxial film 87 of the epitaxial substrate 81, a Schottky electrode film for a gate electrode and the ohmic electrode films for a source electrode and a drain electrode are deposited. The Schottky electrode and ohmic electrodes are formed from the Schottky electrode film and the ohmic electrode films, respectively. It is possible to thin a portion of AlGaN epitaxial film 87 immediately under the Schottky electrode, and to form the Schottky electrode on the portion. This makes it possible to lower the source resistance, improve the mutual conductance, and carry out the normally off. Alternatively, n-type dopant can be added to form an n-type semiconductor region immediately under the source electrode and the drain electrode. Furthermore, an n-type semiconductor regions to which the n-type dopant is added may be grown as a contact layer on the surface of the AlGaN epitaxial film 87, and the source electrode and/or the drain electrode may be formed on the contact layer. Accordingly, the contact resistance can be reduced. Furthermore, a portion of the AlGaN layer can be thinned, and the source and/or the drain electrode can be formed on the thinned portion. Accordingly, the contact resistance can be reduced. Or the source and/or drain electrode can be formed to be in contact with the GaN layer, which has a band gap smaller than that of AlGaN, by removing the AlGaN layer. Accordingly, the contact resistance can be reduced.
The surface roughness of the AlGaN region is used to indicate the crystal quality to monitor the quality of AlGaN film with which the Schottky electrode constitutes a Schottky junction, so that an epitaxial substrate can be provided for a semiconductor device in which a backward leak current that flows through the Schottky junction when a voltage is applied across the Schottky electrode and the ohmic electrode can be reduced.

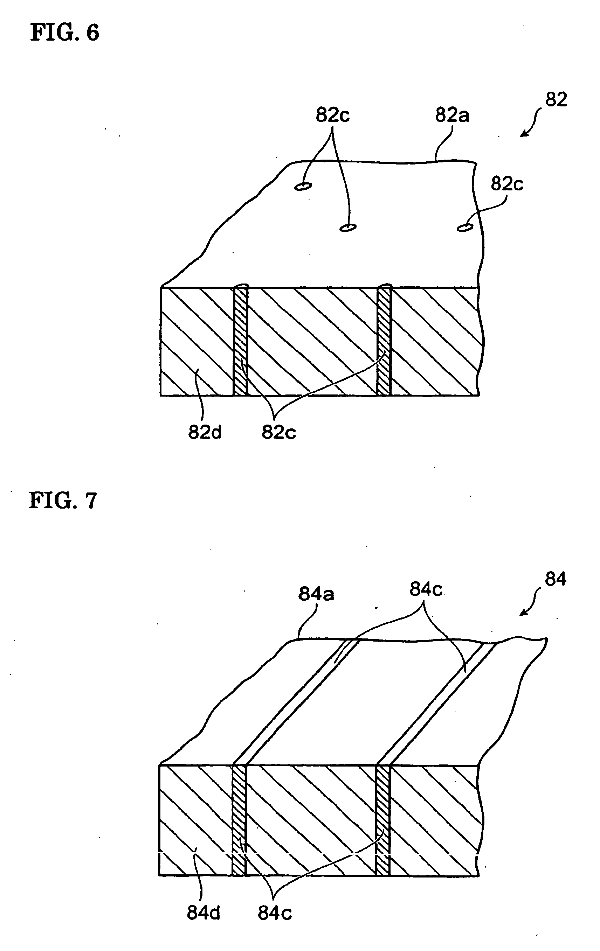

Fig. 6 is a view representing one example of locations of high dislocation regions and low dislocation regions in a gallium nitride freestanding substrate for Embodiment Modes 1 and 2. A first surface 82a of the gallium nitride freestanding substrate 82 for the epitaxial substrate 81 includes first areas where high dislocation regions 82c having a relatively large method of manufacturing an dislocation density appear, and a second area where a low dislocation region 82d having a relatively small method of manufacturing an dislocation density appears. The high dislocation regions 82c are surrounded by the low dislocation region 82d, and the first areas are randomly distributed in a dot-like pattern in the second area on the first surface 82a. As a whole, the method of manufacturing an dislocation density is 1×10⁸ cm⁻² or less, for example. The epitaxial substrate 81 gives an epitaxial layer having a lowered dislocation density in the low dislocation region 82d. Consequently, the backward leak current is reduced and the backward breakdown voltage is improved.

Fig. 7 is a view representing another example of locations of the high dislocation regions and the low dislocation regions in a gallium nitride freestanding substrate for Embodiment Modes 1 and 2. A first surface 84a of the gallium nitride freestanding substrate 84 for the epitaxial substrate 81 includes first areas where high dislocation regions 84c having a relatively large method of manufacturing an dislocation density appear, and second areas where low dislocation regions 84d having a relatively small method of manufacturing an dislocation density appear. The high dislocation regions 84c are surrounded by the low dislocation regions 84d, and the first areas are distributed in a striped pattern in the second area on the first surface 84a. As a whole, the method of manufacturing an dislocation density is 1×10⁸ cm⁻² or less, for example. The epitaxial substrate 81 gives an epitaxial layer having a lowered dislocation density in the low dislocation regions 84d. Accordingly, the backward leak current is decreased, and the backward breakdown voltage is improved.

In the present embodiment, as in Embodiment Mode 1, as a freestanding substrate, the AlₓGa₁₋ₓN (0≤x≤1) substrate can be used. More specifically, the freestanding substrate can be composed of AlN, AlGaN or GaN.

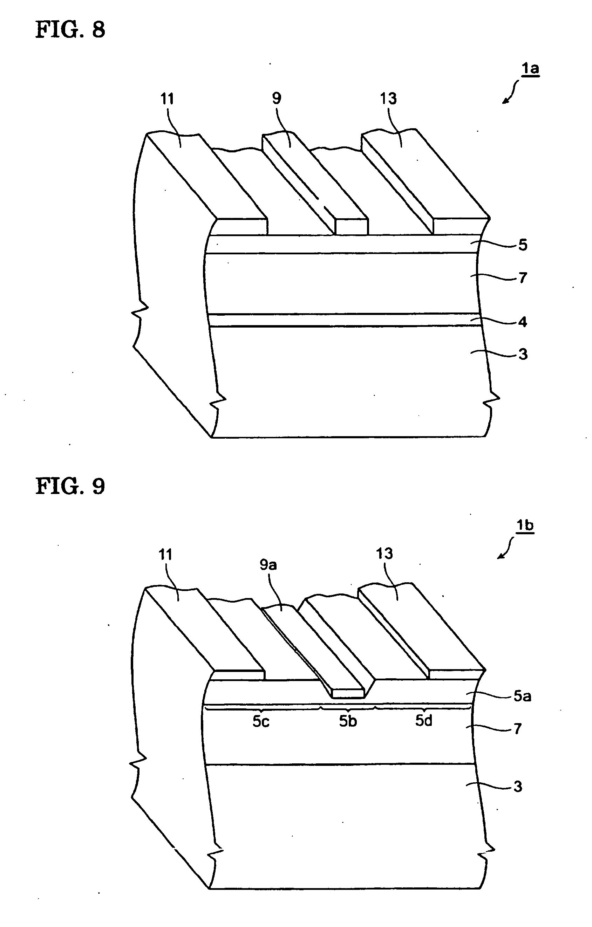

The present embodiment includes various modifications. Fig. 8 is a view representing the high electron mobility transistor according to one modification of Embodiment Mode 1. Referring to Fig. 8, in a high electron mobility transistor 1a, an additional gallium nitride semiconductor layer 4 can be provided between the GaN epitaxial layer 7 and the gallium nitride supporting substrate 3. The gallium nitride semiconductor layer 4 is composed of AlN, GaN, AlGaN, InGaN, or AlInGaN, for example. The gallium nitride semiconductor layer 4 restrains the affect of defects of and impurities on the supporting substrate from propagating to the upper layers, thereby improving the quality of the GaN epitaxial layer 7.

Fig. 9 is a view representing the high electron mobility transistor according to other modification of Embodiment Mode 1. A high electron mobility transistor 1b can be provided with an AlGaN layer 5a in place of the AlGaN layer 5 of the high electron mobility transistor 1a. The AlGaN layer 5a includes a first portion 5b, a second portion 5c and a third portion 5d. The first portion 5b is positioned between the second portion 5c and the third portion 5d. The thickness of the first portion 5b is smaller than that of the second portion 5c and that of the third portion 5d, thereby forming a recess structure in the AlGaN layer 5a. On the first portion 5b, a gate electrode 9a is provided. The recess structure is formed by thinning the Al_{y}Ga_{1-y}N epitaxial layer 15 by etching. The recess gate structure makes it possible to reduce the source resistance, improve the mutual conductance, and perform a normally off.

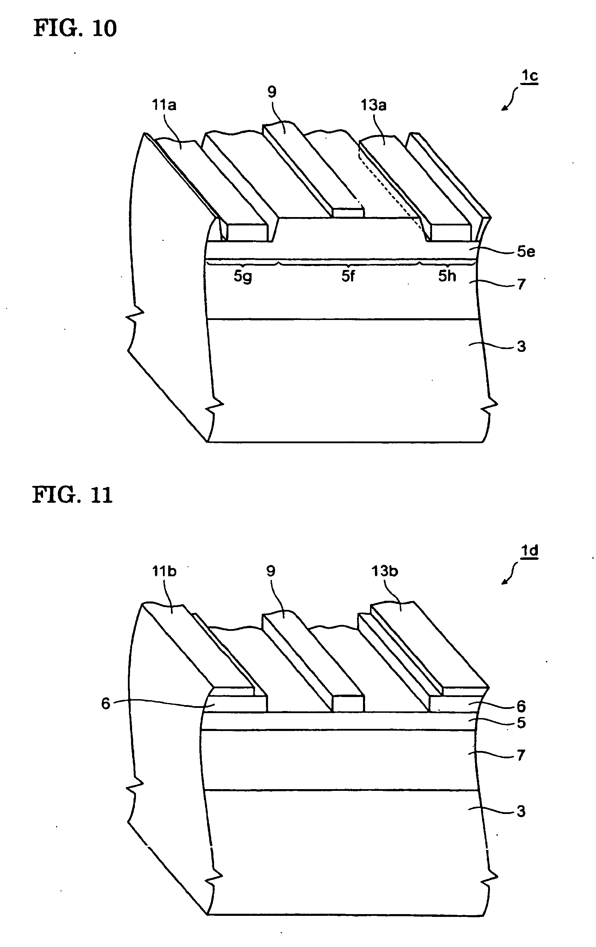

Fig. 10 is a view representing the high electron mobility transistor according to other modification of Embodiment Mode 1. A high electron mobility transistor 1c can be provided with, in place of the AlGaN layer 5 of the high electron mobility transistor 1a, an AlGaN layer 5e. The AlGaN layer 5e includes a first portion 5f, a second portion 5g, and a third portion 5h. The first portion 5f is positioned between the second portion 5g and the third portion 5h. The thickness of the first portion 5f is larger than that of the second portion 5g and that of the third portion 5h, thereby forming a recess structure in the AlGaN layer 5e. The recess structure is formed by thinning the Al_{y}Ga_{1-y}N epitaxial layer 5e by etching. On the second portion 5g, a source electrode 11a is provided. On the third portion 5h, a drain electrode 13a is provided. The recess ohmic structure can reduce the contact resistance.

Fig. 11 is a view representing the high electron mobility transistor according to other modification of Embodiment Mode 1. A high electron mobility transistor 1d may be further provided with contact layers 6 on the AlGaN layer 5 of the high electron mobility transistor 1a for a source electrode and a drain electrode. The contact layers 6 can be composed of gallium nitride semiconductors such as GaN, InN, and InGaN. The band gap of the contact layer 6 is preferably smaller than that of the AlGaN layer 5. The carrier concentration of the contact layer 6 is preferably larger than that of the AlGaN layer 5. The gate electrode 9 constitutes a Schottky junction with the AlGaN layer 5, and a source electrode 11b and a drain electrode 13b constitute ohmic contacts with contact layers 6. The contact layers 6 are positioned between the source electrode 11b and the AlGaN layer 5, and between the drain electrode 13b and the AlGaN layer 5. The contact layer added structure can also reduce the contact resistance.

## Claims

1. A method of manufacturing an epitaxial substrate for a Group III nitride semiconductor device, comprising the steps of:
providing an AlₓGa₁₋ₓN substrate(0 ≤ x ≤ 1) (83);
growing by MOVPE the following layers:
a buffer layer composed of any of AIN, GaN, AlGaN, InGaN, and AlInGaN on the substrate;
on the buffer layer a GaN epitaxial film (85) by supplying trimethylgallium (TMG) and NH₃ at a temperature of 600 deg C to 1200 deg C and at a pressure of 1 kPa to 120 kPa and at a thickness of 0.5 um to 1000 um at a carrier concentration of <= 1 × 10¹⁷ per cm³; and
on the GaN epitaxial film an Al_{y}Ga₁₋ₓN epitaxial film (0 < y ≤ 1) (5, 25, 35, 87) by supplying trimethylaluminum (TMA), trimethylgallium (TMG) and NH₃ having a surface roughness (RMS) of 0.25 nm or less defined in a square area measuring 1 µm per side at a temperature of 600 deg C to 1200 deg C and at a pressure of 1kPa to 120 kPa and at a thickness of 5 nm to 50 nm at a carrier concentration of <= 1 × 10¹⁹ per cm³.

2. The method as set forth in claim 1,
**characterized in that**
the aluminum mole fraction y of said Al_{y}Ga₁₋ₓN epitaxial film is between 0.1 and 0.7, inclusive.

3. The method set forth in any of claims 1 or 2 ,
**characterized in that**
said AlₓGa₁₋ₓN substrate is a gallium nitride substrate.

## Patentansprüche

1. Verfahren zum Herstellen eines Epitaxie-Substrats für eine Halbleitervorrichtung aus Gruppe-III-Nitrid, wobei es die folgenden Schritte umfasst:
Bereitstellen eines AlₓGa₁₋ₓN-Substrats (0 ≤ × ≤ 1) (83);
Züchten der folgenden Schichten durch MOVPE:
einer Puffer-Schicht, die aus AIN, GaN, AlGaN, InGaN und AllnGaN besteht, auf dem Substrat;
eines GaN-Epitaxie-Films (85) auf der Puffer-Schicht durch Zuführen von Trimethylgallium (TMG) und NH₃ bei einer Temperatur von 600 °C bis 1200 °C und einem Druck von 1 kPa bis 120 kPa sowie in einer Dicke von 0,5 µm bis 1000 µm bei einer Trägerkonzentration ≤ 1 × 10¹⁷ pro cm³; und
eines Al_{y}Ga_{1-y}N-Epitaxie-Films (0 < y≤ 1) (5, 25, 35, 87) auf dem GaN-Epitaxie-Film durch Zuführen von Trimethylaluminium (TMA), Trimethylgallium (TMG) und NH₃ mit einer Oberflächenrauhigkeit (RMS) von 0,25 nm oder weniger, definiert in einem quadratischen Bereich, der 1 µm pro Seite misst, bei einer Temperatur von 600 °C bis 1200 °C und einem Druck von 1 kPa bis 120 kPa sowie einer Dicke von 5 nm bis 50 nm bei einer Trägerkonzentration ≤ 1 × 10¹⁹ pro cm³.

2. Verfahren nach Anspruch 1,
**dadurch gekennzeichnet, dass**
der Aluminium-Molenbruch y des Al_{y}Ga_{1-y}N-Epitaxie-Films zwischen einschließlich 0,1 und einschließlich 0,7 beträgt.

3. Verfahren nach einem der Ansprüche 1 oder 2,
**dadurch gekennzeichnet, dass**
das Al_{y}Ga₁₋ₓN-Substrat ein Galliumnitrid-Substrat ist.

## Revendications

1. Procédé de fabrication d'un substrat épitaxial pour un composant à semiconducteur en nitrure de groupe III, comprenant les étapes consistant à :
procurer un substrat d' AlₓGa₁₋ₓN (0 ≤ × ≤ 1) (83),
faire croître par épitaxie MOVPE les couches suivantes :
une couche tampon composée de l'un quelconque de l'AlN, du GaN, de l'AlGaN, du InGaN et de l'AlInGaN sur le substrat,
sur la couche tampon, un film épitaxial de GaN (85) obtenu en fournissant du triméthyl-gallium (TMG) et du NH₃ à une température allant de 600 degrés C à 1200 degrés C et à une pression allant de 1 kPa à 120 kPa, avec une épaisseur allant de 0,5 µm à 1000 µm et avec une concentration de porteurs inférieure ou égale à 1 × 10¹⁷ par cm³, et
sur le film épitaxial de GaN, un film épitaxial d'Al_{y}Ga_{1-y}N (0 ≤ y ≤ 1) (5, 25, 35, 87) obtenu en fournissant du triméthyl-aluminium (TMA), du triméthyl-gallium (TMG) et du NH₃ présentant une rugosité de surface (rugosité RMS) de 0,25 nm ou moins définie dans une surface carrée mesurant 1 µm de côté à une température allant de 600 degrés C à 1200 degrés C et à une pression allant de 1 kPa à 120 kPa, avec une épaisseur allant de 5 nm à 50 nm et avec une concentration de porteurs inférieure ou égale à 1 × 10¹⁹ par cm³.

2. Procédé selon la revendication 1,
**caractérisé en ce que**
la fraction molaire y d'aluminium dudit film épitaxial d'Al_{y}Ga_{1-y}N se situe entre 0,1 et 0,7, inclus.

3. Procédé selon la revendication 1 ou 2,
**caractérisé en ce que**
ledit substrat d'AlₓGa₁₋ₓN est un substrat de nitrure de gallium.
